Europäisches Patentamt

European Patent Office

Office européen des brevets

(19)

(11) Publication number : **0 239 913 B2**

(12) **NEW EUROPEAN PATENT SPECIFICATION**

(45) Date of publication of the new patent
specification : **10.05.95 Bulletin 95/19**

(51) Int. Cl.$^6$ : **G11C 11/407**, G11C 11/409

(21) Application number : **87104318.8**

(22) Date of filing : **22.10.81**

(54) Semiconductor memory circuit.

(30) Priority : **22.10.80 JP 147771/80**
**22.10.80 JP 147773/80**

(43) Date of publication of application :
**07.10.87 Bulletin 87/41**

(45) Publication of the grant of the patent :
**10.10.90 Bulletin 90/41**

(45) Mention of the opposition decision :
**10.05.95 Bulletin 95/19**

(84) Designated Contracting States :
**DE FR GB NL**

(56) References cited :
**US-A- 4 004 284**
**1979 IEEE INTERNATIONAL SOLID-STATE**
**CIRCUITS CONFERENCE, 15th February 1979,**
**pages 142,143, IEEE, New York, US; J.M. LEE**
**et al.: "Session XII: Dynamic memories-A**
**80ns 5V-only dynamic RAM"**
**PATENT ABSTRACTS OF JAPAN, vol. 3, no.**
**124 (E-144), 17th October 1979 & JP-A-54-101**
**230**

(56) References cited :
**IEEE International Sloid-State Circuits Confer-**
**ence, 15 February 1979, pages 140-141. FOSS:**
**"The Design of MOS Dynamic Memories"**
**IEEE International Solid-State Circuits Confer-**
**ence, 15 February 1979, pages 20-21. HELLER:**
**"Cross-Coupled Charge-Transfer Sense Am-**
**plifier"**

(60) Publication number of the earlier application in
accordance with Art. 76 EPC : **0 050 529**

(73) Proprietor : **FUJITSU LIMITED**
**1015, Kamikodanaka**
**Nakahara-ku**
**Kawasaki-shi Kanagawa 211 (JP)**

(72) Inventor : **Takemae, Yoshihiro**
**13-24-303, Akasaka 8-chome**
**Minato-ku**
**Tokyo 107 (JP)**

(74) Representative : **Fane, Christopher Robin King**
**et al**
**HASELTINE LAKE & CO.**
**Hazlitt House**
**28 Southampton Buildings**
**Chancery Lane**
**London, WC2A 1AT (GB)**

EP 0 239 913 B2

## Description

The present invention relates to a semiconductor memory circuit and, more particularly, to a dynamic semiconductor memory circuit which employs rows and columns provided with so-called one-transistor storage cells.

In recent years, the one-transistor storage cell type memory device has been widely utilized as a random access memory (RAM) device of the MIS integrated semiconductor memory circuit type. Such a RAM device has already been disclosed in U.S. Patent No. 4,045,783 or U.S. Patent No. 4,195,357, and can have many advantages over a conventional RAM. However, such a RAM also suffers from some defects.

One such defect resides in that errors in the RAM system may occur due to a change in the level of a backgate voltage ($V_{BB}$) for biassing the substrate, such a change of $V_{BB}$ being brought about as a result of a voltage change occurring in a bit (column) line. The backgate voltage $V_{BB}$ is supplied either by an external biassing generator, or, in more recent RAM circuits, by an internal biassing generator that derives the backgate voltage from the voltage between the high-voltage and low-voltage lines which supply operating power to the circuit. A RAM of this latter type, having an internal biassing generator, is described in "Dynamic Memories - A 80ns 5V-only dynamic RAM" by J.M. Lee et al (published on pages 142-143 of 1979 IEEE International Solid-State Circuits Conference).

This RAM, the operating power of which is supplied by way of respective high-voltage and low-voltage lines thereof, may be considered to comprise: a plurality of bit line pairs; a plurality of word lines; one-transistor memory cells located at respective points at which the word lines cross the bit lines; an internal biassing generator, provided on a substrate of the said memory circuit and deriving from the voltage between the said high-voltage and low-voltage lines a backgate voltage, lower than the potential of the said low-voltage line, for biassing the said substrate; and pre-charging circuitry arranged for charging the bit line pairs, before commencement of a read operation, to a pre-charge voltage; such a read operation being effected by employing a word line of the said plurality to select an associated memory cell and thereby connect that cell to a bit line of the associated bit line pair so as to cause the potential of that bit line to be increased or decreased in dependence upon whether the memory cell concerned held a data "1" or a data "0", whereupon a sense amplifier connected between the two bit lines of the pair brings about a reduction in the potential of the lower-voltage bit line of the pair towards the potential of the said low-voltage line, and pull-up circuitry connected to that bit line pair causes the potential of the higher-voltage bit line of the pair to be pulled up towards the potential of the said high-voltage line.

Although the above RAM needs less supply voltage lines, its internal biassing generator operates with an internally generated backgate voltage that is low compared with that generated by an external biassing generator, and its pre-charge voltage is equal to the high-voltage line potential, so that unwanted changes in $V_{BB}$ such as are mentioned above may be more troublesome.

Another dynamic RAM is described in "Dynamic Memories - The Design of MOS Dynamic RAMs" by R. C. Foss (published on pages 140-141 of 1979 IEEE International Solid-State Circuits Conference). In order to avoid coupling a large positive transient into the -$V_{BB}$ supply when using an internal biassing generator, this document proposes shorting (or charge sharing) the bit lines at the end of a cycle to derive a half voltage level during precharging.

However, in the DRAM disclosed in this document the bit lines are shorted using a common connection line which connects all the bit lines together during precharging to accomplish the required charge sharing. This approach can render the equalisation of the bit line potentials of a pair relatively slow. There is no suggestion in the document that the two bit lines of each pair should be shorted directly together to improve the speed of response.

According to the present invention the said pre-charge voltage is derived by a voltage divider from the respective potentials of the said high-voltage and low-voltage lines in such a manner as to be half-way between those potentials; and the said pre-charging circuitry is operable, for each of the said bit line pairs, to cause the two bit lines of the pair to be connected directly together via a single transistor during precharging.

US-A-4,004,284 discloses a semiconductor memory circuit having pre-charging circuitry arranged for charging two nodes of the memory circuit, before a read operation, to a pre-charge voltage derived, in one example by a voltage divider, from the respective potentials of high-voltage and low-voltage lines of the memory circuit so as to half-way between those potentials. However, this prior art circuitry does not include an internal biassing generator, nor is it concerned with overcoming the general problem of avoiding errors due to unwanted changes in backgate voltage.

Reference will now be made, by way of example, to the accompanying drawings, in which:

Fig 1 illustrates a circuit diagram of a conventional one-transistor storage cell type RAM circuit;

Fig. 2 depicts a graph, used for explaining the operation of the circuit shown in Fig. 1;

2

Fig. 3 illustrates a circuit diagram of another conventional one-transistor storage cell type RAM circuit;

Fig. 4 depicts a graph, used for explaining the operation of the circuit shown in Fig. 3;

Fig. 5 illustrates a circuit diagram of a further conventional one-transistor storage cell type RAM circuit;

Fig. 6 depicts a graph, used for explaining a "0" read operation of the circuit shown in Fig. 5;

Fig. 7 depicts a graph, used for explaining a "1" read operation of the circuit shown in Fig. 5;

Fig. 8 illustrates a circuit diagram of a semiconductor memory circuit embodying the present invention;

Fig. 9 depicts a graph, used for explaining a "0" read operation of the circuit shown in Fig. 8;

Fig. 10 depicts a graph, used for explaining a "1" read operation of the circuit shown Fig. 8;

Fig. 11 illustrates an example of a dynamic pull-up circuit shown in Fig. 8;

Fig. 12 comprises first graphs, illustrating voltage changes in the circuit of Fig. 1 or Fig. 3; and

Fig. 13 comprises second graphs, relating to an embodiment of the present invention.

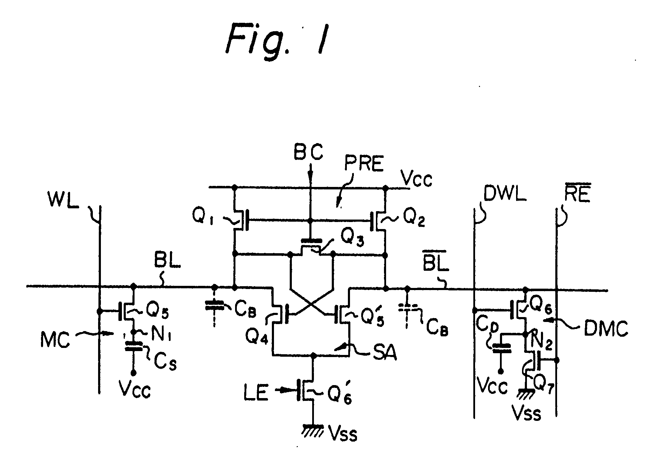

In Fig. 1 a sense amplifier SA comprises MIS transistors $Q_4$, $Q_5$ and $Q_6$, and is controlled by a signal LE. The reference symbols BL and $\overline{BL}$ represent a pair of bit lines which extend leftward and rightward respectively from the sense amplifier SA. The reference symbol PRE represents a pre-charge circuit comprising MIS transistors $Q_1$, $Q_2$ and $Q_3$. MC represents a memory cell comprising a MIS transistor $Q_5$, acting as a transfer-gate transistor,and a MIS capacitor $C_S$, acting as a storage capacitor. The capacitor $C_S$ has a pair of electrodes and the first electrode thereof is connected, via a node $N_1$, to the transistor $Q_5$. The reference symbol DMC represents a dummy cell comprising MIS transistors $Q_6$ and $Q_7$ and also a MIS capacitor $C_D$. The reference symbol WL represents a word line. A signal, appearing on the word line WL, makes the transfer-gate transistor $Q_5$ ON, then the stored information of the memory cell MC is transferred to the bit line BL. The reference symbol DWL represents a dummy word line. A signal, appearing on the dummy word line DWL, makes the MIS transistor $Q_6$ ON, then the dummy capacitor $C_D$ is connected with the bit line $\overline{BL}$ The reference symbol $\overline{RE}$ indicates a signal which makes the transistor $Q_7$ ON so as to discharge the capacitor $C_D$. That is, the voltage level at the node $N_2$ is changed to the low voltage level of a memory power source, specifically the voltage level $V_{SS}$ which is usually 0 V. The reference symbol BC indicates a signal which makes MIS transistors $Q_1$, $Q_2$ and $Q_3$ ON simultaneously so that the level of both bit lines BL and $\overline{BL}$ is changed to the high level of the memory power source, specifically the voltage level $V_{CC}$ which is usually 5 V. That is, the signal BC acts as a pre-charging signal. The bit lines BL and $\overline{BL}$ form the bit line parasitic capacitor $C_B$. The high voltage level $V_{CC}$ of the memory power source is also applied to one of the electrodes of each capacitor $C_S$ and $C_D$.

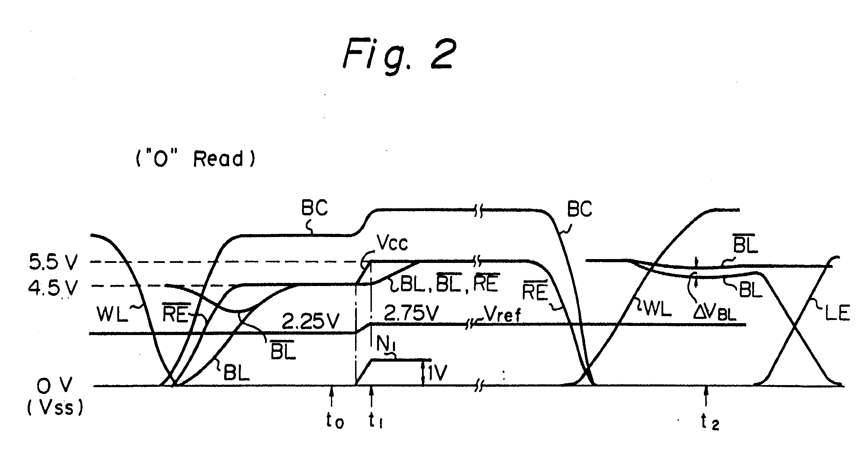

The graph of Fig. 2 indicates the operation of the circuit shown in Fig. 1 when information "0" is read from the memory cell MC. The level of the word line WL is changed to the low voltage level $V_{SS}$ after a write operation or a refresh operation has finished. Then the signals BC and $\overline{RE}$ are activated. Therefore, the bit lines BL and $\overline{BL}$ are pre-charged to the high voltage level $V_{CC}$, and the level at the node $N_2$, in the dummy cell DMC, is changed to the lower voltage level $V_{SS}$, which is called stand-by status.

Generally, a semiconductor memory circuit must accept a power source voltage change of ±10%. Accordingly, when the high voltage level of the memory power source is designed to be 5 V, the semiconductor memory circuit must be designed so as to operate without any error even though the power source voltage changes within the range between 4.5 V and 5.5 V. Returning to Fig. 2, the graph depicts, for example,a case where firstly information "0" has been written, during a condition of $V_{CC}$ = 4.5 V, in the memory cell, i.e. the level at the node $N_1$ is changed to the level $V_{SS}$, and secondly the written information "0" has been read from the memory cell MC at a time $t_2$. However, a voltage change has occurred during the stand-by status, especially during the period from $t_0$ to $t_1$, from the level 4.5 V to 5.5 V. As is known, the capacity of the dummy capacitor $C_D$ and the capacity of the memory cell $C_S$ are determined so as to satisfy the following equation (1).

$$C_D = \frac{1}{2} C_S \quad (1)$$

(Note the symbols $C_D$ and $C_S$ also denote the capacities of respective capacitors $C_D$ and $C_S$.)

If the power source voltage level is still maintained at 4.5 V up to and after the time $t_2$, contrary to the graph of Fig. 2, each voltage drop produced in the bit lines BL and $\overline{BL}$ is respectively expressed by about

$$V_{CC} \frac{C_D}{C_B} \text{ and } V_{CC} \frac{C_S}{C_B}$$

according to the above equation (1). That is, when the word line WL is activated (the dummy word line DWL is also activated), current flows from the bit lines $\overline{BL}$ and BL into the capacitors $C_S$ and $C_D$ respectively, via the nodes $N_1$ and $N_2$, and thus the voltage levels of the bit lines $\overline{BL}$ and BL are reduced by about the values of the aforesaid expressions

$$V_{CC} \frac{C_D}{C_B} \text{ and } V_{CC} \frac{C_S}{C_B}.$$

Accordingly, the voltage level $V_{\overline{BL}}$ of the bit line $\overline{BL}$ and the voltage level $V_{BL}$ of the bit line BL are respectively expressed by the following equations (2) and (3).

$$V_{\overline{BL}} = V_{CC} - V_{CC}\frac{C_D}{C_B} = 4.5 - 4.5\frac{C_D}{C_B}$$

$$= 4.5 - \frac{4.5}{2}\frac{C_S}{C_B} \quad (2)$$

$$V_{BL} = V_{CC} - V_{CC}\frac{C_S}{C_B} = 4.5 - 4.5\frac{C_S}{C_B} \quad (3)$$

From the above equations (2) and (3), the voltage difference $\Delta V_{BL}$, between the voltages of the bit lines BL and $\overline{BL}$ can be expressed by the following equation (4).

$$\Delta V_{BL} = |V_{BL} - V_{\overline{BL}}| = 2.25\frac{C_S}{C_B}(V) \quad (4)$$

However, in Fig. 2, a voltage change of the power source occurs during the period $t_0$ through $t_1$ and the increased voltage 5.5 is maintained thereafter. In such case, the voltage level ($V_{N1}$) at the node $N_1$ is pushed upward, via the capacitor $C_S$, by the aforesaid voltage increase of 1 (= 5.5 - 4.5) V. Thus, the voltage levels $V_{\overline{BL}}$ and $V_{BL}$ of the bit lines $\overline{BL}$ and BL, respectively, are expressed by the following equations (5) and (6).

$$V_{\overline{BL}} = V_{CC} - V_{CC}\frac{C_D}{C_B} = 5.5 - 5.5\frac{C_D}{C_B}$$

$$= 5.5 - \frac{5.5}{2}\frac{C_S}{C_B} \quad (5)$$

$$V_{BL} = V_{CC} - (V_{CC} - V_{N1})\frac{C_S}{C_B} = V_{CC} - (V_{CC} - 1.0)\frac{C_S}{C_B}$$

$$= 5.5 - 4.5\frac{C_S}{C_B} \quad (6)$$

As a result, the difference voltage $\Delta V_{BL}$, during the read operation after the time $t_2$, is reduced as defined by the following equation (7).

$$\Delta V_{BL} = |V_{BL} - V_{\overline{BL}}| = 1.75\frac{C_S}{C_B} \quad (7)$$

It should be understood that, in the circuit of Fig. 1, the above mentioned reduction of voltage level (refer to the change in the above equations from (4) to (7)) cannot occur during the read operation of information "1". The reason is as follows. When information "1" is to be written in the memory cell MC, the voltage level at the node $N_1$ is changed to the level of $V_{CC}$. Therefore, when the above write operation finishes, the voltage level at the node $N_1$ is equal to 4.5 V. If the voltage increase to 5.5 V occurs thereafter, the voltage level at the node $N_1$ is pushed upward, via the capacitor $C_S$, to 5.5 V. Under such circumstance, no charges are extracted from the bit line BL during the read operation of information "1", but charges, proportional to the value of $\frac{1}{2}C_S$, are extracted from the bit line $\overline{BL}$, which operation is the same as the usual read operation when there is no change in the power source voltage. The reference symbol $V_{ref}$ indicates a threshold voltage level utilized for distinguishing between the "1" level and the "0" level.

As mentioned above, since the capacitors $C_S$ and $C_D$ are energized, at each one electrode thereof, by the voltage level $V_{CC}$, the above mentioned voltage reduction

$$(2.25\frac{C_S}{C_B} \rightarrow 1.75\frac{C_S}{C_B})$$

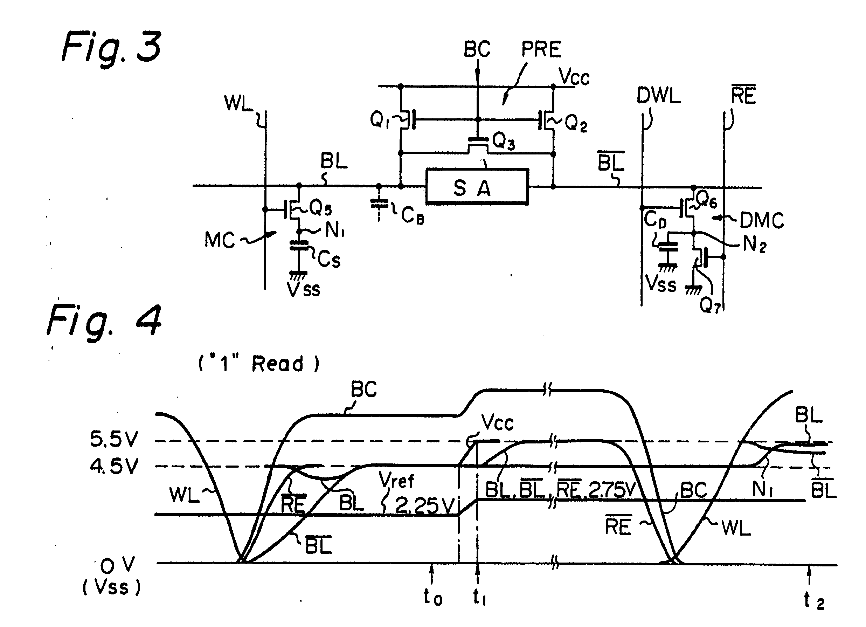

is induced during the "0" read operation. Contrary to the above, the voltage level $V_{CC}$ at the capacitors $C_S$ and $C_D$ of Fig. 1 can be substituted for the voltage level $V_{SS}$ through a manufacturing process in which, for example, impurities are injected, through an ion implantation process, into the areas located under the capacitors $C_S$ and $C_D$, where the impurities have a conductivity type opposite to that of the substrate. If the voltage level $V_{CC}$ at the capacitors $C_S$ and $C_D$ is replaced by the voltage level $V_{SS}$, there is a possibility that no voltage level change at the node $N_1$ will occur regardless of the power source voltage changes. Fig. 3 illustrates a circuit diagram of another conventional one-transistor storage cell type RAM circuit. In the circuit of Fig. 3, the above mentioned $V_{SS}$ is employed instead of $V_{CC}$ at the capacitors $C_S$ and $C_D$. The circuit of Fig. 3 can overcome the voltage reduction of $\Delta V_{BL}$ during the "0" read operation. However, contrary to this, identical voltage reduction of $\Delta V_{BL}$ is created during the "1" read operation. The graph of Fig. 4 depicts the "1" read operation of the circuit shown in Fig. 3. Firstly, information "1" has been written in the memory cell MC under the condition of $V_{CC}$ = 4.5 V, and secondly the change of the power source voltage occurs during the period from the time $t_0$ to $t_1$, that is the voltage $V_{CC}$ is increased from 4.5 V to 5.5 V. If the power source voltage level is still maintained at 4.5 V up to and after the time $t_2$, contrary to the graph of Fig. 4, the voltage level $V_{\overline{BL}}$ is defined by the following equation (8).

$$V_{\overline{BL}} = V_{CC} - V_{CC}\frac{C_D}{C_B} = 4.5 - \frac{4.5}{2}\frac{C_S}{C_B} \quad (8)$$

In such a circumstance, since the stored information of "1" at the node $N_1$ is represented by 4.5 V, no charges are extracted from the bit line BL to the node $N_1$ when the word line WL is activated, and thus the following equation (9) is obtained.

$$V_{BL} = V_{CC} = 4.5\,V \quad (9)$$

From the above equations (8) and (9), the voltage difference $\Delta V_{BL}$ is expressed as follows.

$$\Delta V_{BL} = |V_{BL} - V_{\overline{BL}}| = 2.25\frac{C_S}{C_B} \quad (10)$$

The value $\Delta V_{BL}$ of the equation (10) is the same as that of the equation (4), and therefore, no voltage reduction is induced. However, if the power source voltage ($V_{CC}$) is increased, during the stand-by status as shown in Fig. 4, from 4.5 V to 5.5 V, the voltage level $V_{\overline{BL}}$ of the bit line $\overline{BL}$ is defined as follows.

$$V_{\overline{BL}} = V_{CC} - V_{CC}\frac{C_D}{C_B} = 5.5 - 5.5\frac{C_D}{C_B}$$

$$= 5.5 - \frac{5.5}{2}\frac{C_S}{C_D} \quad (11)$$

At this time, even though the voltage level $V_{CC}$ is increased to 5.5 V, the voltage level $V_{N1}$ at the node $N_1$ is maintained as it is, that is 4.5 V, because the transfer-gate transistor $Q_5$ is now OFF. Therefore, current flows from the bit line BL to the memory cell MC and the voltage level $V_{BL}$ can be defined as follows.

$$V_{BL} = V_{CC} - (V_{CC} - V_{N1})\frac{C_S}{C_B} = 5.5 - (5.5 - 4.5)\frac{C_S}{C_B}$$

$$= 5.5 - \frac{C_S}{C_B} \quad (12)$$

Consequently, the voltage difference $\Delta V_{BL}$, at the time $t_2$ for achieving the read operation, is defined as follows.

$$\Delta V_{BL} = |V_{BL} - V_{\overline{BL}}| = 1.75\frac{C_S}{C_B} \quad (13)$$

As understood from the above recited equations (7) and (13), the undesired voltage reduction of $\Delta V_{BL}$ is inevitable in each of the circuits illustrated in Figs. 1 and 3.

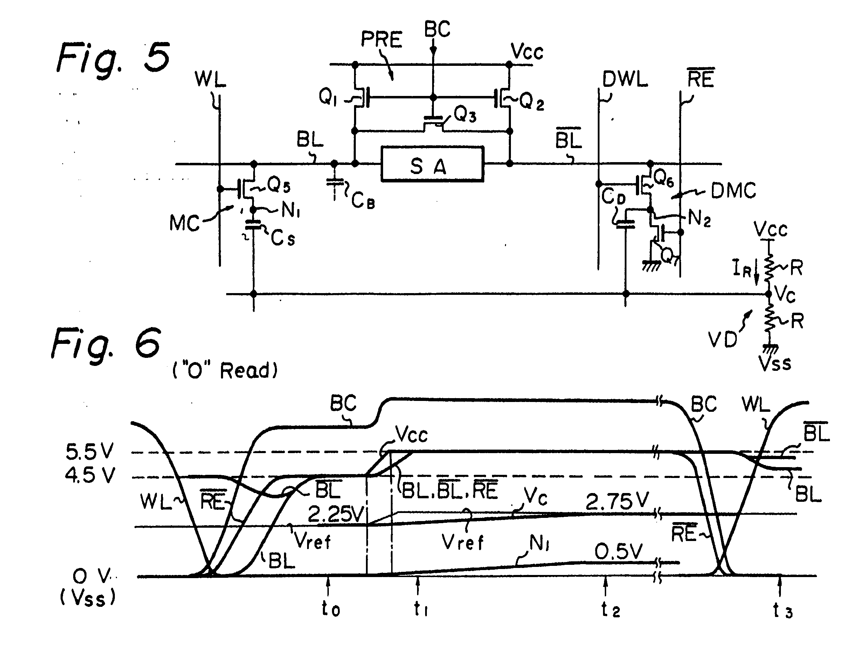

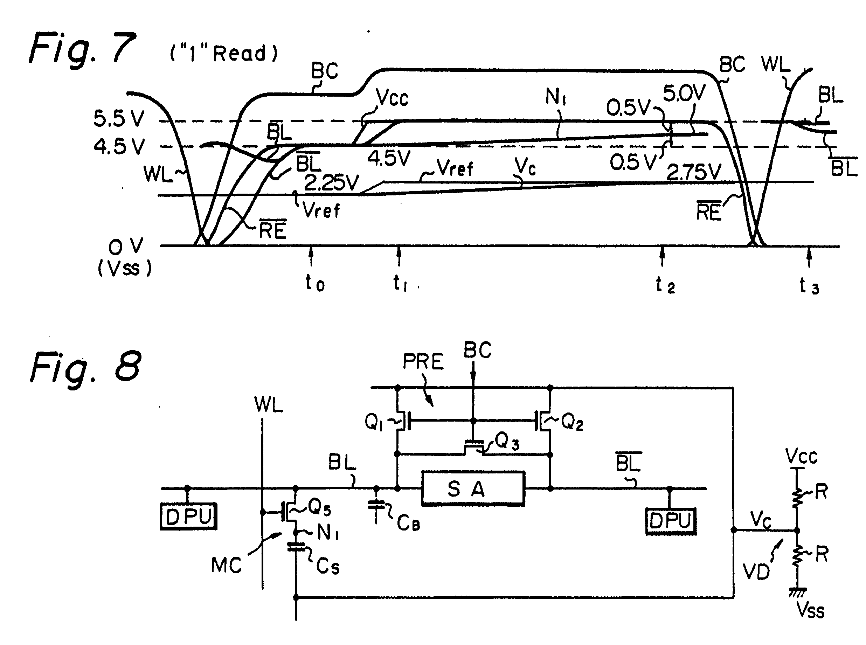

Fig. 5 illustrates a circuit diagram of a conventional one-transistor storage cell type RAM circuit which contains an improvement regarding undesired voltage reduction of $\Delta V_{BL}$. Fig. 6 depicts a graph, used for explaining the "0" read operations of the circuit shown in Fig. 5. Also, Fig. 7 depicts a graph, used for explaining the "1" read operation of the circuit shown in Fig. 5. As seen from Fig. 5, the improvement is specifically represented by a voltage divider VD having two resistors R. The voltage divider VD produces output voltage of $V_C$ which is equal to half of $V_{CC}$ ($V_C = \frac{1}{2}V_{CC}$). The voltage $V_C$ is applied to both the capacitors $C_S$ and $C_D$, at each one electrode thereof. In the circuit of Fig. 5, when the write operation of information "0" is achieved at the condition of $V_{CC} = 4.5$ V and the read operation thereof is also achieved at the condition of $V_{CC} = 4.5$ V, the voltage difference $\Delta V_{BL}$, during the read operation, is determined by the following equation (14).

$$\Delta V_{BL} = 2.25\frac{C_S}{C_B} \quad (14)$$

If the power source voltage $V_{CC}$ changes from 4.5 V to 5.5 V during the period from the time $t_0$ to $t_1$, as illustrated in Fig. 6, and at the same time if the time $t_2$ is longer than the time $t_1$, the following equations (15) and (16) can be obtained, because the voltage level $V_C$ and the voltage level ($V_{N1}$) at the node $N_1$ change in such a manner as depicted in Fig. 6.

$$V_{\overline{BL}} = V_{CC} - V_{CC}\frac{C_D}{C_B} = 5.5 - 5.5\frac{C_D}{C_B} = 5.5 - \frac{5.5}{2}\frac{C_S}{C_B}$$

$$= 5.5 - 2.75\frac{C_S}{C_B} \quad (15)$$

$$V_{BL} = V_{CC} - (V_{CC} - V_{N1})\frac{C_S}{C_B} = 5.5 - (5.5 - 0.5)\frac{C_S}{C_B}$$

$$= 5.5 - 5\frac{C_S}{C_B} \quad (16)$$

Consequently, the voltage difference $\Delta V_{BL}$, at the time $t_2$ for achieving the read operation, is expressed as follows.

$$\Delta V_{BL} = |V_{BL} - V_{\overline{BL}}| = 2.25\frac{C_S}{C_B} \quad (17)$$

It should be noted that the equation (17) is identical to the equation (14) and no voltage reduction of $\Delta V_{BL}$ is induced, which is also true in the case where the "1" read operation is conducted. That is if the voltage level $V_{cc}$ is kept constant at 4.5 V, the voltage difference $\Delta V_{BL}$ is expressed by the equation (18).

$$\Delta V_{BL} = 2.25 \frac{C_S}{C_B} \quad (18)$$

Similarly, even though the voltage level $V_{cc}$ changes during the period from time $t_0$ to $t_1$, if the read time $t_2$ is far longer than the time $t_1$, the following two equations stand.

$$V_{\overline{BL}} = V_{CC} - V_{CC}\frac{C_D}{C_B} = 5.5 - \frac{5.5}{2}\frac{C_S}{C_B} \quad (19)$$

$$V_{BL} = V_{CC} - (V_{CC} - V_{N1})\frac{C_S}{C_B} = 5.5 - (5.5 - 5)\frac{C_S}{C_B}$$

$$= 5.5 - 0.5\frac{C_S}{C_B} \quad (20)$$

From the equations (19) and (20), the voltage difference $\Delta V_{BL}$ at the time $t_2$ includes no undesired voltage reduction, as represented by the following equation (21).

$$\Delta V_{BL} = \left| V_{BL} - V_{\overline{BL}} \right| = 2.25 \frac{C_S}{C_B} \quad (21)$$

This equation (21) is identical to the above recited equation (18).

The circuit of Fig. 5 is satisfactory from the view represented by the equations (17), (18) and (21). However, at the same time it has the following defects. The resistance value of each of the resistors R in Fig. 5 must be increased so as to reduce the power consumption produced from the resistors R. However, since the resistance value thereof is large, the voltage $V_C$ cannot quickly follow the change in $V_{cc}$. Accordingly, if the time $t_2$ is close to the time $t_1$, the value of $\Delta V_{BL}$ becomes small. For example, in a large capacity RAM which is of the order of 64 k bits, the capacity developed at the middle junction of resistors R in the voltage divider VD becomes about 1000 pF. If the resistance value of the resistor R is determined to be 2R = 50 k$\Omega$, so as to suppress the amount of current $I_R$ below 0.1 mA, then the time constant $\tau$ in a change of $V_C$, when the voltage level $V_{cc}$ changes, is determined as follows. That is, $\tau = 2R \cdot C = 50 \ \mu S$, which value of $\tau$ is extremely large. Due to the presence of such a large time constant $\tau$ in $V_C$, if the read operation is commenced immediately after the time $t_1$, the voltage difference $\Delta V_{BL}$ is reduced as defined by the following equation (22).

$$\Delta V_{BL} = 1.75 \frac{C_S}{C_B} \quad (22)$$

This equation (22) is identical to the above recited equation (13).

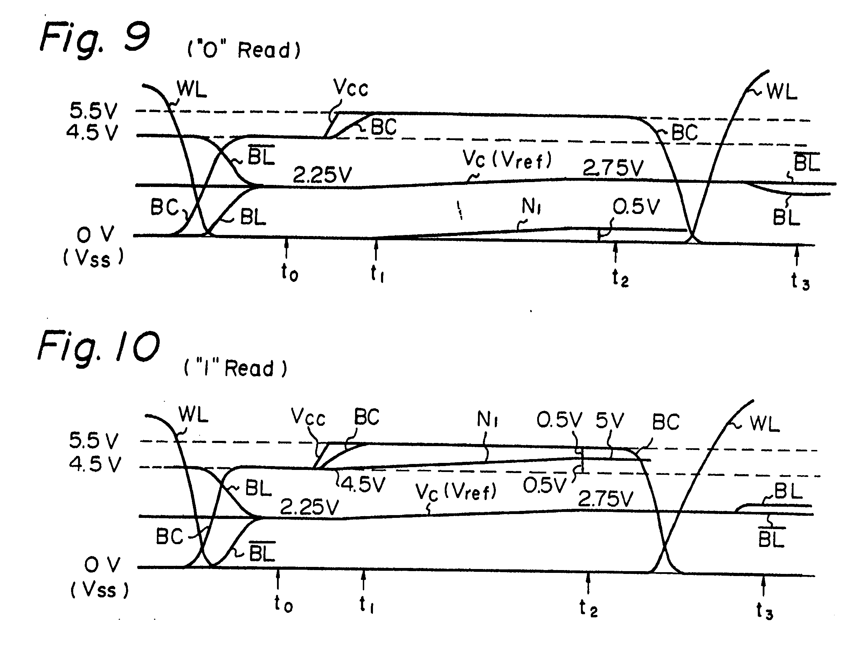

Circuitry embodying the present invention can improve the reduction of the voltage difference $\Delta V_{BL}$ represented by the equation (22), so that the voltage difference $\Delta V_{BL}$ is always kept at a constant large value even if a change of the power source voltage occurs at any time. In an embodiment of the present invention pre-charging circuitry, known as first circuitry, is employed for supplying the pre-charge voltage to the pre-charge circuit PRE, the level of that pre-charge voltage being defined as half-way between the high voltage level and the low voltage level developed at the bit line. Also auxiliary circuitry, known as second circuitry, may be employed for supplying a predetermined voltage to the capacitor $C_S$ at the second electrode thereof. The said predetermined voltage to be supplied from said second circuitry is exactly the same as the voltage to be supplied from said first circuitry, the level of which voltage is defined as half-way between the said high voltage level and the low voltage level developed at the bit line. Fig. 8 illustrates a circuit diagram of a semiconductor memory circuit embodying the present invention. Fig. 9 depicts a graph, used for explaining the "0" read operation of the circuit shown in Fig. 8. And, Fig. 10 depicts a graph, used for explaining the "1" read operation of the circuit shown in Fig. 8.

In Fig. 8 the first circuitry supplies a pre-charge voltage to the pre-charge circuit PRE. The second circuitry supplies a predetermined voltage to the capacitor $C_S$, at the second electrode thereof. The term "second electrode" has already been explained with reference to Fig. 1. Preferably, the predetermined voltage from the second circuitry is exactly the same as the voltage from the first circuitry. Further, the output voltages from the said first and second circuitry are defined as half-way between the high voltage level developed as the bit line and the low voltage level developed at the same bit line. Furthermore, said high voltage level and low voltage level may be selected to be $V_{cc}$ and $V_{ss}$ of the memory power source respectively. In this case, a dynamic pull-up circuit is necessary. Since the first and second circuitry produce the same output voltage, that is $\frac{1}{2}(V_{cc} + V_{ss})$, these circuits are fabricated as a single voltage divider. The circuit of Fig. 8 corresponds to a circuit which contains the above mentioned single voltage divider VD and the above mentioned dynamic pull-up circuits DPU. Referring to Fig. 8, this circuit is different from that of Fig. 5 from the following two view points. Firstly, the output voltage $V_C$ being equal to $\frac{1}{2}(V_{cc} + V_{ss})$ from the voltage divider VD, is also applied to the pre-charge circuit PRE, Secondly, the voltage level of both the bit lines BL and $\overline{BL}$ , appearing during the stand-by status, becomes ½ $V_{CC}$ , which level ½ $V_{CC}$ has been pre-charged by the circuit PRE, and accordingly, the voltage itself of the bit line $\overline{BL}$ can be utilized as the aforesaid reference voltage $V_{ref}$. This suggests that the dummy cell DMC could be removed from the circuits illustrated in Figs. 1, 3 and 5, as shown in Fig. 8, and the dynamic pull-up circuits DPU then connected to the bit lines BL and $\overline{BL}$. Although the dummy cell DMC is not illustrated in Fig. 8, however, this DMC should be retained, because such a cell serves for suppressing undesired noise.

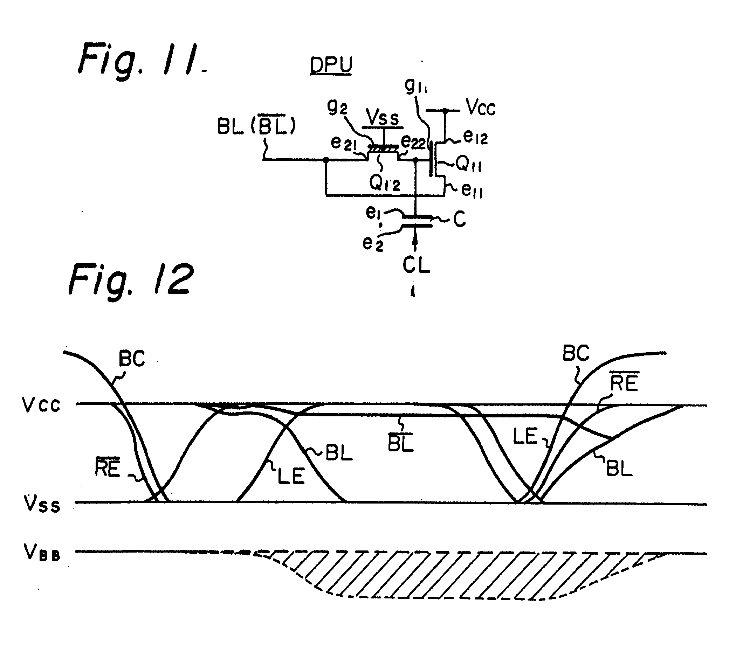

Fig. 11 illustrates one example of the dynamic pull-up circuit shown in Fig. 8. The dynamic pull-up circuit DPU is connected to each of the bit lines BL and $\overline{BL}$ so as to lead the aforesaid high voltage level of $V_{CC}$ thereto. The circuit DPU is comprised of an enhancement type MIS transistor $Q_{11}$ , having a gate g1 and first and second electrodes e11 and e12, a depletion type MIS transistor $Q_{12}$ , having a gate g2 and first and second electrodes e21 and e22, and a capacitor C, having a first electrode e1 and a second electrode e2 which receives a clock pulse CL. The first electrodes e11 and e21 of the said MIS transistors $Q_{11}$ and $Q_{12}$ respectively are connected with the bit line BL ($\overline{BL}$ ). The second electrode e22 of the depletion type MIS transistor, the gate g1 of the enhancement type MIS transistor and the first electrode e1 of the capacitor are commonly connected together. The gate g2 of the depletion type MIS transistor receives the voltage $V_{SS}$ and the second electrode e12 of the enhancement type MIS transistor receives the voltage $V_{CC}$. When the clock CL is supplied, the voltage level at the gate g1 is pushed upward over the voltage level of $V_{CC}$ under a bootstrap effect. However, this bootstrap effect becomes effective only when the voltage level of the bit line BL (or $\overline{BL}$ ) is high. If the voltage level is low, current flows through the transistor $Q_{12}$ , and accordingly the voltage level at the gate g1 does not increase. As a result, if the voltage level of the bit line is high, the transistor $Q_{11}$ is turned ON and the bit line is charged toward the level $V_{CC}$ , while, if the voltage level of the bit line is low, the transistor $Q_{11}$ is not turned ON and the bit line is not charged.

Returning to Fig. 8, after the write operation or refresh operation is performed with respect to the memory cell MC at the level $V_{CC}$ of 4.5 V and then the voltage level is changed to $V_{SS}$ , the voltage level of the bit line $\overline{BL}$ becomes 4.5 V and the voltage level of the bit line BL becomes 0 V, as shown in Fig. 9. Thereafter, the signal BC is activated and the transistors $Q_1$ , $Q_2$ and $Q_3$ are turned ON. Then the charges on the bit line $\overline{BL}$ are distributed to the bit line BL and thereby the voltage level of each of the bit lines has the same value of 2.25 (= ½ x 4.5) V. Thereafter the aforesaid stand-by status begins from the time $t_0$ , in which the voltage level of each bit line cannot be changed by, for example a junction-leak current due to the voltage divider VD, and the voltage level 2.25 V is fixedly maintained.

When the read operation is commenced, the word line WL is activated and the aforesaid voltage difference $\Delta V_{BL}$ between the bit lines BL and $\overline{BL}$ is created in accordance with the information stored in the memory cell MC. Next, the sense amplifier SA is driven so that the low voltage level of one of the bit lines is pulled down toward the level $V_{SS}$ , while, the high voltage level of the other bit line is pulled up toward the level $V_{CC}$ by means of one of the corresponding dynamic pull-up circuits DPU. Thus, the voltage difference therebetween is considerably amplified. The amplified difference voltage is transferred, via a column line (not shown), to a read-write amplifier (not shown).

The operations of the circuit shown in Fig. 8 will be explained with reference to Figs. 9 and 10.

1) In the case of a "0" read operation, if the voltage level is fixedly maintained to be $V_{CC} = 4.5$ V, the voltage level $V_{\overline{BL}}$ of the bit line $\overline{BL}$ does not change, because no dummy cell DMC exists as is illustrated in Fig. 8. Thus, the following equation is obtained.

$$V_{\overline{BL}} = V_C = 2.25 \text{ V} \quad (23)$$

While, the voltage level $V_{BL}$ of the bit line BL is expressed by the following equation.

$$V_{BL} = V_C - V_C \frac{C_S}{C_B} = 2.25 \text{ V} - 2.25 \frac{C_S}{C_B} \quad (24)$$

From the above equations (23) and (24), the following equation, regarding the voltage difference, is obtained.

$$\Delta V_{BL} = \left| V_{BL} - V_{\overline{BL}} \right| = 2.25 \frac{C_S}{C_B} \quad (25)$$

2) In the case of a "0" read operation, if the voltage level $V_{CC}$ changes, during the stand-by status, from 4.5 V to 5.5 V and the read operation is commenced immediately after the time $t_1$ , the result is the same as that mentioned in the above paragraph 1). This is because, close to the time $t_1$ , as seen from Fig. 9, the voltage level at $N_1$ is about 0 V and besides, the voltage level $V_C$ is kept almost at 2.25 V due to the presence of the aforementioned time constant$\tau$.

3) In the case of a "0" read operation, if the voltage level $V_{CC}$ changes from 4.5 V to 5.5 V and the read operation is commenced at the time $t_2$ being far longer than the time $t_1$ ,

EP 0 239 913 B2

$$V_{\overline{BL}} = V_C = \frac{5.5}{2} = 2.75 \text{ V} \quad (26)$$

$$V_{BL} = V_C - (V_C - V_{N1})\frac{C_S}{C_B}$$

$$= 2.75 - (2.75 - 0.5)\frac{C_S}{C_B}$$

$$= 2.75 - 2.25\frac{C_S}{C_B} \quad (27)$$

From the equations (26) and (27), the following equation

$$\Delta V_{BL} = |V_{BL} - V_{\overline{BL}}| = 2.25\frac{C_S}{C_B} \quad (28)$$

is obtained.

4) In the case of a "1" read operation, if the voltage level is fixedly maintained to be $V_{cc}$ = 4.5 V, the following equations (29) and (30) are obtained, regarding the bit lines $\overline{BL}$ and BL.

$$V_{\overline{BL}} = V_C = 2.25 \text{ V} \quad (29)$$

$$V_{BL} = V_C + (V_{CC} - V_C)\frac{C_S}{C_B}$$

$$= 2.25 + (4.5 - 2.25)\frac{C_S}{C_B}$$

$$= 2.25 + 2.25\frac{C_S}{C_B} \quad (30)$$

From the equations (29) and (30), the following equation

$$\Delta V_{BL} = |V_{BL} - V_{\overline{BL}}| = 2.25\frac{C_S}{C_B} \quad (31)$$

is obtained.

5) In the case of a "1" read operation, if the voltage level $V_{cc}$ varies, during the stand-by status, from 4.5 V to 5.5 V and the read operation is commenced immediately after the time $t_1$, the voltage level $V_c$ is held at about 2.25 V and the voltage level at the node $N_1$ is held at about 4.5 V, the result is the same as that mentioned in the above paragraph 4).

6) In the case of a "1" read operation, if the voltage level $V_{cc}$ changes from 4.5 V to 5.5 V and the read operation is commenced at the time $t_2$ being far longer than the time $t_1$, the following equations

$$V_{\overline{BL}} = V_C = \frac{5.5}{2} = 2.75 \text{ V} \quad (32)$$

$$V_{BL} = V_C + (V_{CC} - 0.5 - V_C)\frac{C_S}{C_B}$$

$$= 2.75 + (5.5 - 0.5 - 2.75)\frac{C_S}{C_B}$$

$$= 2.75 + 2.25\frac{C_S}{C_B} \quad (33)$$

are obtained.

From the equations (32) and (33), the following equation

$$\Delta V_{BL} = |V_{BL} - V_{\overline{BL}}| = 2.25\frac{C_S}{C_B} \quad (34)$$

is obtained.

The cases, mentioned in the above paragraphs 2), 3), 5) and 6) correspond to all possible cases, in which, first the "0" write or "1" write operation has been performed in the memory cell MC under a condition of $V_{cc}$ = 4.5 V. In such cases, the aforesaid results, corresponding to the equations (28) and (34), are identical, corresponding to the equations (25) and (31) which are obtained in the cases where the read operations are commenced under a condition of $V_{cc}$ = 4.5 V (not 5.5 V).

As explained above, read error, due to the voltage change of the memory power source, can be eliminated. Further, three advantages are newly produced, the first one being that no dummy cell DMC is required for constructing the RAM, the second one being that a high speed read operation is expected, because the read operation can be commenced immediately after the time $t_1$, and the third one being that power consumption can be reduced in the RAM, because a very large resistance value of each of the resistors R in the voltage divider VD is allowed.

The pre-charging circuitry of Fig. 8 also deals with the problem that error in a RAM system may occur as

8

a result of a change in the level of he backgate voltage ($V_{BB}$) for biassing the substrate, which change of $V_{BB}$ is brought about in consequence of a voltage change developed at the bit lines BL and $\overline{BL}$. Thus the afore-mentioned first circuitry is very useful for suppressing the change in the back-gate voltage $V_{BB}$. The first circuitry, asmentioned above, functions to supply a pre-charge voltage to the pre-charge circuit PRE, and the pre-charge voltage is defined as just half-way between the levels $V_{CC}$ and $V_{SS}$. In this case, the previously mentioned auxiliary, or second, circuitry functions to supply a predetermined voltage to the capacitor $C_S$, i.e. to its second electrode, this predetermined voltage being ½ ($V_{CC} + V_{SS}$).

Fig. 12 depicts a first graph used for explaining how $V_{BB}$ changes in proportion to the voltage of the line BL. This first graph is obtained when the semiconductor memory circuit of Fig. 1 or Fig. 3 is used. The meanings of respective reference symbols used in Fig. 12 have already been explained with reference to earlier Figures. In Fig. 12, the change in the backgate voltage $V_{BB}$should be noted, which change is indicated by hatched lines surrounded by broken lines. The reason why the voltage $V_{BB}$ changes in such a wide range as illustrated in Fig. 12, will be explained hereinafter. The backgate voltage, that is, the voltage of the substrate $V_{BB}$, was determined in the prior art by an external biassing voltage generator. However, an embodiment of the present invention does not operate with such an external biassing voltage generator, but has an internal biassing generator in the RAM system itself, which system operates from just a single power source of 5 V ($V_{CC}$). In this case, it is difficult to generate high power biassing voltage, compared to that which could be obtained from an external biassing voltage generator, and accordingly merely a low power biassing voltage is generated in the system. To make the matter worse, since the bit lines BL and $\overline{BL}$ are fabricated by diffusion layers, a great amount of PN-junction capacity is created between the bit lines and the substrate. As a result, if a big change in the voltage level occurs in either one of the bit lines, this change of voltage is directly transmitted to the substrate, via the above-mentioned large PN-junction capacity. This is the reason why a relatively large change in $V_{BB}$ occurs. For example, in Fig. 12, the voltage level $V_{BB}$ changes proportionally to the voltage change of the bit line BL. If a large voltage change occurs in the bit line BL, the voltage level $V_{BB}$may undergo a proportionately large change.

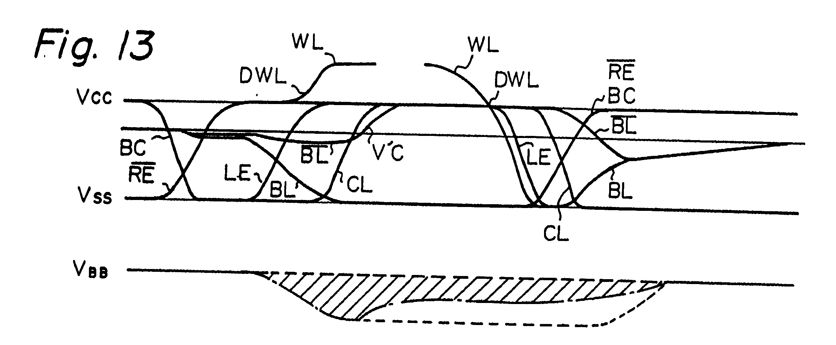

Fig. 13 depicts a second graph used for explaining the change of $V_{BB}$. The second graph indicates an improvement with respect to the change of $V_{BB}$ shown in Fig. 12. As seen from Fig. 13, the change in $V_{BB}$, which is indicated by hatched lines surrounded by a chain-dotted line, is reduced as compared with the change in $V_{BB}$ shown in Fig. 12, also illustrated in Fig. 13 by a broken line. This is because the pre-charge voltage of both the bit lines BL and $\overline{BL}$ is reduced from the level $V_{CC}$ to the level $V_{C'}$ which is illustrated in Fig. 13.

The circuit construction shown in Fig. 8, embodying the present invention, more particularly the aforementioned first circuitry, is very useful for suppressing change in $V_{BB}$. The first circuitry (VD), as previously mentioned, functions to supply the pre-charge voltage ($V_C$) to the pre-charge circuit PRE, and the pre-charge voltage is derived so as to be half-way between the levels $V_{CC}$ and $V_{SS}$. In this case, the previously mentioned second circuitry functions to supply a predetermined voltage to the capacitor $C_S$, i.e to its second electrode, the predetermined voltage being ½ ($V_{CC} + V_{SS}$). In the circuit of Fig. 8, since the pre-charge voltage is deter-mined to be ½($V_{CC} + V_{SS}$), the change in $V_{BB}$ caused by an upward voltage shift of one bit line is almost cancelled by the change in $V_{BB}$ caused by a downward voltage shift of the other bit line,thereby considerably decreasing the overall change in $V_{BB}$.

It should be noted that the circuitry of Figures 8 and 11 provides the subject-matter also of the applicant's European patent application number 81304967.3 (published under number 0050529).

## Claims

1. A semiconductor memory circuit, the operating power of which is supplied by way of respective high-voltage ($V_{CC}$) and low-voltage ($V_{SS}$) lines thereof, which circuit comprises: a plurality of bit line pairs (BL, $\overline{BL}$); a plurality of word lines (WL); one-transistor memory cells (MC) located at respective points at which the word lines cross the bit lines; an internal biassing generator, provided on a substrate of the said memory circuit and deriving from the voltage between the said high-voltage and low-voltage lines a backgate voltage ($V_{BB}$), lower than the potential ($V_{SS}$) of the said low-voltage line, for biassing the said substrate; and pre-charging circuitry (PRE) arranged for charging the bit line pairs (BL, $\overline{BL}$), before commencement of a read operation, to a pre-charge voltage ($V_C$); such a read operation being effected by employing a word line (WL) of the said plurality to select an associated memory cell (MC) and thereby connect that cell to a bit line of the associated bit line pair so as to cause the potential of that bit line to be increased or decreased in dependence upon whether the memory cell concerned held a data "1" or a data "0", where-upon a sense amplifier (SA) connected between the two bit lines of the pair brings about a reduction in the potential of the lower-voltage bit line of the pair towards the potential ($V_{SS}$) of the said low-voltage line, and pull-up circuitry (DPU) connected to that bit line pair (BL, $\overline{BL}$) causes the potential of the higher-voltage bit line of the pair to be pulled up towards the potential ($V_{CC}$) of the said high-voltage line;

characterised in that the said pre-charge voltage ($V_C$) is derived by a voltage divider (VD) from the respective potentials ($V_{CC}$ and $V_{SS}$) of the said high-voltage and low-voltage lines in such a manner as to be half-way between those potentials; and further characterised in that the said pre-charging circuitry (PRE) is operable, for each of the said bit line pairs, to cause the two bit lines of the pair to be connected directly together via a single transistor ($Q_3$) during precharging.

2. A circuit as claimed in claim 1, wherein each of the said memory cells (MC) is comprised of a capacitor ($C_S$), having a first electrode and a second electrode, and a transfer-gate transistor ($Q_5$) connected in series with the capacitor ($C_S$) at the first electrode thereof, there being auxiliary circuitry connected for applying to each said capacitor at the second electrode thereof a predetermined voltage the level of which is half-way between the respective potential ($V_{CC}$ and $V_{SS}$) of the said high-voltage and low-voltage lines.

3. A circuit as claimed in claim 2, wherein the said predetermined voltage and the said pre-charge voltage ($V_C$) are taken from a common output point of the said voltage divider (VD).

4. A semiconductor memory circuit as claimed in any preceding claim, wherein the said pull-up circuitry (DPU) comprises an enhancement type MIS transistor ($Q_{11}$), having a gate ($g_1$), a first electrode ($e_{11}$) connected with a bit line (BL, $\overline{BL}$), and a second electrode ($e_{12}$) connected to receive the potential ($V_{CC}$) of the said high-voltage line; a depletion type MIS transistor ($Q_{12}$), having a gate ($g_2$) connected to receive the potential ($V_{SS}$) of the said low-voltage line, a first electrode ($e_{21}$) connected with the said bit line (BL, $\overline{BL}$), and second electrode ($e_{22}$) connected to the said gate ($g_1$) of the enhancement type MIS transistor ($Q_{11}$); and a capacitor (C), having a first electrode ($e_1$) connected to the said second electrode ($e_{22}$) of the depletion type MIS transistor ($Q_{12}$), and a second electrode ($e_2$) connected to receive a clock pulse (CL).

**Patentansprüche**

1. Halbleiterspeicherschaltung, deren Betriebsspannung über entsprechende Hochspannungs-(Vcc)- und Niederspannungs-(Vss)-Leitungen von ihr zugeführt wird, welche Schaltung umfaßt: eine Vielzahl von Bitleitungspaaren (BL, $\overline{BL}$); eine Vielzahl von Wortleitungen (WL); ein-Transistor-Speicherzellen (MC), die an entsprechenden Punkten angeordnet sind, an denen die Wortleitungen die Bitleitungen kreuzen; einen internen Vorspannungsgenerator, der auf einem Substrat der genannten Speicherschaltung vorgesehen ist und von der Spannung zwischen den genannten Hochspannungs- und Niederspannungsleitungen eine Rückgatespannung ($V_{BB}$) ableitet, die niedriger als das Potential ($V_{SS}$) der genannten Niederspannungsleitung ist, die das genannte Substrat vorzuspannen; und eine Vorladeschaltung (PRE), die angeordnet ist, um die Bitleitungspaare (BL, $\overline{BL}$) vor Beginn eines Lesebetriebs auf eine Vorladespannung ($V_C$) zu laden; wobei solch ein Lesebetrieb durch Verwendung einer Wortleitung (WL) der genannten Vielzahl durchgeführt wird, um eine zugeordnete Speicherzelle (MC) auszuwählen und dadurch jene Zelle mit einer Bitleitung des zugeordneten Bitleitungspaares zu verbinden, um so zu bewirken, daß das Potential von jener Bitleitung erhöht oder erniedrigt wird, abhängig davon, ob die betreffende Speicherzelle einen Datenwert "1" oder einen Datenwert "0" hielt, woraufhin ein Leseverstärker (SA), der zwischen den beiden Bitleitungen des Paares verbunden ist, eine Reduktion des Potentials der Niederspannungsbitleitung des Paares zu dem Potential ($V_{SS}$) der genannten Niederspannungsleitung herbeiführt, und eine pull-up-Schaltung (DPU), die mit jenem Bitleitungspaar (BL, $\overline{BL}$) verbunden ist, bewirkt, daß das Potential der Hochspannungsbitleitung des Paares zu dem Potential ($V_{CC}$) der genannten Hochspannungsleitung hochgezogen wird; dadurch gekennzeichnet, daß die Vorladespannung ($V_C$) durch einen Spannungsteiler (VD) von den entsprechenden Potentialen ($V_{CC}$ und $V_{SS}$) der genannten Hochspannungs- und Niederspannungsleitungen in solch einer Weise abgeleitet wird, daß sie halbwegs zwischen jenen Potentialen liegt, und ferner dadurch gekennzeichnet, daß die genannten Vorladeschaltung (PRE) für jedes der Bitleitungspaare betreibbar ist, um zu bewirken, daß die beiden Bitleitungen des Paares während der Voraufladung direct über einen einzelnen Transistor ($Q_3$) miteinander verbunden werden.

2. Schaltung nach Anspruch 1, bei der jede der genannten Speicherzellen (MC) aus einem Kondensator ($C_S$) besteht, der eine erste und eine zweite Elektrode hat, und einem Transfergatetransistor ($Q_s$), der in Reihe mit dem Kondensator ($C_S$) an dessen erster Elektrode verbunden ist, wobei es eine Hilfsschaltung gibt, die verbunden ist, um jedem genannten Kondensator an seiner zweiten Elektrode eine vorbestimmte Spannung zuzuführen, deren Pegel halbwegs zwischen den entsprechenden Potentialen ($V_{CC}$ und $V_{SS}$) der genannten Hochspannungs- und Niederspannungsleitungen liegt.

3. Schaltung nach Anspruch 2, bei der die genannte vorbestimmte Spannung und die genannte Vorladespannung ($V_C$) von einem gemeinsamen Ausgangspunkt des genannten Spannungsteilers(VD) genomnen wird.

4. Halbleiterspeicherschaltung nach einem der vorhergehenden Ansprüche, bei der die genannte pull-up-Schaltung (DPU) einen MIS-Transistor ($Q_{11}$) vom Anreicherungstyp umfaßt, der ein Gate ($g_1$), eine erste Elektrode ($e_{11}$), die mit einer Bitleitung (BL, $\overline{BL}$) verbunden ist, und eine zweite Elektrode ($e_{12}$) hat, die verbunden ist, um das Potential ($V_{CC}$) der genannten Hochspannungsleitung zu empfangen; einen MIS-Transistor ($Q_{12}$) vom Verarmungstyp, der ein Gate ($g_2$), das verbunden ist, um das Potential ($V_{SS}$) der genannten Niederspannungsleitung zu empfangen, eine erste Elektrode ($e_{21}$), die mit der genannten Bitleitung (BL, $\overline{BL}$) verbunden ist, und eine zweite Elektrode ($e_{22}$) hat, die mit dem genannten Gate ($g_1$) des MIS-Transistors ($Q_{11}$) vom Anreicherungstyp verbunden ist; und einen Kondensator (C), der eine erste Elektrode ($e_1$), die mit der genannten zweiten Elektrode ($e_{22}$) des MIS-Transistors ($Q_{12}$) vom Verarmungstyp verbunden ist, und eine zweite Elektrode ($e_2$), die verbunden ist, um einen Taktimpuls (CL) zu empfangen, hat.

**Revendications**

1. Circuit de mémoire à semiconducteur dont l'alimentation est fournie par ses lignes respectives de tension supérieure ($V_{CC}$) et de tension inférieure ($V_{SS}$), ce circuit comportant : une pluralité de paires de lignes de bits (BL, $\overline{BL}$) ; une pluralité de lignes de mots (WL) ; des cellules de mémoire à un seul transistor (MC) situées aux points respectifs où les lignes de mots croisent les lignes de bits ; un générateur de polarisation interne prévu sur un substrat dudit circuit de mémoire et dérivant, de la tension présente entre lesdites lignes de tension supérieure et de tension inférieure, une tension de contre-grille ($V_{BB}$) inférieure au potentiel ($V_{SS}$) de ladite ligne de tension inférieure, pour polariser ledit substrat ; et un circuit de précharge (PRE) conçu pour charger les paires de lignes de bits (BL, $\overline{BL}$), avant le début d'une opération de lecture, à une tension de précharge ($V_C$) ; cette opération de lecture étant effectuée à l'aide d'une ligne de mots (WL) de ladite pluralité pour sélectionner une cellule de mémoire associée (MC) et connecter ainsi cette cellule à une ligne de bits de la paire de lignes de bits associée de manière à faire que le potentiel de cette ligne de bits soit augmenté ou diminué suivant que la cellule de mémoire considérée contient une donnée "1" ou une donnée "0", de sorte qu'un amplificateur de lecture (SA) connecté entre les deux lignes de bits de la paire produit une réduction du potentiel de la ligne de bits de tension inférieure de la paire vers le potentiel ($V_{SS}$) de la ligne de tension inférieure, et un circuit d'élévation de tension (DPU) connecté à cette paire de lignes de bits (BL, $\overline{BL}$) fait que le potentiel de la ligne de bits de tension supérieure de la paire soit élevé vers le potentiel ($V_{CC}$) de ladite ligne de tension supérieure ;

caractérisé en ce que ladite tension de précharge ($V_C$) est dérivée, par un diviseur de tension, des potentiels respectifs ($V_{CC}$ $V_{SS}$) desdites lignes de tension supérieure et de tension inférieure de manière à se trouver à mi-chemin entre ces potentiels ; et caractérisé en outre en ce que ledit circuit de précharge (PRE) a pour fonction, vis-à-vis de chacune desdites paires de lignes de bits, de faire que les deux lignes de bits de la paire soient directement connectées ensemble par l'intermédiaire d'un unique transistor ($Q_3$) pendant la précharge.

2. Circuit selon la revendication 1, dans lequel chacune desdites cellules de mémoire (MC) est constituée d'un condensateur ($C_S$) ayant une première électrode et une seconde électrode et d'un transistor de porte de transfert ($Q_5$) connecté en série avec le condensateur ($C_S$) par sa première électrode, un circuit auxiliaire étant prévu, connecté pour appliquer à chacun desdits condensateurs, à sa seconde électrode, une tension prédéterminée dont le niveau est à mi-chemin entre les potentiels respectifs ($V_{CC}$) et ($V_{SS}$) desdites lignes de tension supérieure et de tension inférieure.

3. Circuit selon la revendication 2, dans lequel ladite tension prédéterminée et ladite tension de précharge ($V_C$) sont prélevées en un point de sortie commun d'un diviseur de tension (VD).

4. Circuit de mémoire à semiconducteur selon l'une quelconque des revendications précédentes, dans lequel ledit circuit d'élévation de tension (DPU) comporte un transistor MIS ($Q_{11}$) du type enrichi comprenant une grille ($g_1$), une première électrode ($e_{11}$) connectée à une ligne de bits (BL, $\overline{BL}$) et une seconde électrode ($e_{12}$) connectée pour recevoir le potentiel ($V_{CC}$) de ladite ligne de tension supérieure ; un transistor MIS ($Q_{12}$) du type appauvri comprenant une grille ($g_2$) connectée pour recevoir le potentiel ($V_{SS}$) de ladite ligne de tension inférieure, une première électrode ($e_{21}$) connectée à ladite ligne de bits (BL, $\overline{BL}$) et une seconde électrode ($e_{22}$) connectée à ladite grille ($g_1$) dudit transistor MIS ($Q_{11}$) du type enrichi ; et un condensateur (C) comprenant une première électrode ($e_1$) connectée à ladite seconde électrode ($e_{22}$) dudit transistor MIS ($Q_{12}$) du type appauvri et une seconde électrode ($e_2$) connectée pour recevoir une impulsion d'horloge (CL).

# Fig. 1

EP 0 239 913 B2

# Fig. 2

("O" Read)

Fig. 3

Fig. 4
("1" Read)

Fig. 5

Fig. 6 ("O" Read)

EP 0 239 913 B2

EP 0 239 913 B2

## Fig. 7 ("1" Read)

## Fig. 8

## Fig. 9 ("O" Read)

Fig. 9 ("O" Read)

WL, Vcc, BC, 5.5V, 4.5V, $\overline{BL}$, 2.25V, $V_C$ ($V_{ref}$), 2.75V, BC, WL, $\overline{BL}$, BC, BL, $N_1$, 0.5V, BL, 0 V ($V_{SS}$), $t_0$, $t_1$, $t_2$, $t_3$

## Fig. 10 ("1" Read)

Fig. 10 ("1" Read)

WL, $V_{cc}$, BC, $N_1$, 0.5V, 5V, BC, WL, 5.5 V, 4.5 V, BL, 4.5V, $V_C$ ($V_{ref}$), 0.5V, 2.75V, $\overline{BL}$, BC, 2.25V, BC, $\overline{BL}$, BL, $\overline{BL}$, 0 V ($V_{SS}$), $t_0$, $t_1$, $t_2$, $t_3$

Fig. 11.

Fig. 12

EP 0 239 913 B2

Fig. 13